# EUROPEAN PATENT APPLICATION

(11) **EP 0 620 662 A1**
(43) Date of publication of application: **19.10.1994**
(21) Application number: 93200442.7
(22) Date of filing: 16.02.1993
(51) Int. Cl.: H04J 3/04, H04J 3/08

(54) **Processing, serializing and synchronizing device**

(71) Applicant: ALCATEL BELL Naamloze Vennootschap, B-2018 Antwerpen 1 (BE)
(72) Inventor: De Laender, Jos Camiel Irène, B-9620 Zottegem (BE); Meylemans, Philippe, B-3009 Winksele (BE)

(57) **Abstract**

The processing, serializing and synchronizing device includes a processing means (P) which is able to process a plurality of digital signals at a clock frequency f and is reset by a first reset signal (R1), a serializing and synchronizing circuit (S) which multiplexes the digital signals and generates a signal (OUT) synchronous with a clock signal (CLK) with frequency 4f and is reset by the second reset signal (R3), and a control circuit (C) which generates from the latter clock signal (CLK) and from a second reset signal (R2), a clock signal (CLK4BUF) with frequency f and controlling the processing means (P), and the first reset signal (R1) as well as a second reset signal (R3), the latter reset signal being used to reset the serializing and synchronizing circuit (S). The phase relation between the clock signals and the reset signals is such that signals (I0-I3) provided by the processing means (P) are stable when being applied to the serializing and synchronizing circuit (S), i.e. that the latter signals are not multiplexed at their value transitions. Moreover, thanks to the control of the delay circuit by both the first and the second clock signal, the multiplexing instants are independent of the relative phase shift of the clock signals provided that the latter shift is theoretically larger than 0 and smaller than 3 clock periods of the first mentioned clock signal (CLK).

## Description

The present invention relates to a processing, serializing and synchronizing device including a processing means able to process a plurality of digital signals under control of a first clock signal and to be reset by a first reset signal, a serializing and synchronizing circuit able to be reset by a second reset signal and including a multiplexing device to convert the thus processed plurality of digital signals to a serialized output signal synchronous with a second clock signal, and a control circuit generating said first and second clock signals.

Such a device is for instance used in a telecommunication system to process an incoming data stream at a lower rate than its input rate and to derive from the thus processed stream an output data stream at an output rate equal or even higher than the input rate. More particularly the processing means for instance demultiplexes the incoming data stream to provide the plurality of digital signals which can then be processed at a lower rate than the input rate, i.e. at the rate of the first clock signal, and the serializing and synchronizing circuit multiplexes the processed digital signals at the rate of the second clock signal which is at least equal to the input rate.

When the first reset signal is independent from the the second one and from the clock signals and when the serializing and synchronizing circuit operates without knowledge of the phase relationship between both the clock signals, it may happen that the processed digital signals supplied to the multiplexing device are undefined because the serializing and synchronizing circuit is for instance reset while the processing means is still supplying undefined data, or that the multiplexing of the processed digital signals occurs at transitions thereof. The latter situation can happen at start up or after a not known interval of time due to a shift of the first clock with respect to the second one because of , e.g., temperature variations. The processed digital signals have then to be synchronized for instance by a relative phase shift of the first clock with respect to the incoming signal, resulting in a possible value jump of the output data, i.e. a skipping of output data bits. Moreover, such a possible jump makes testing of the device rather difficult since the output signal can then not be uniquely defined with respect to the input signal because the instant at which the jump occurs is unknown.

An object of the present invention is to provide a processing, serializing and synchronizing device of the above known type but wherein no data skipping occurs , i.e. where the processed digital signals are always synchronized with the second clock signal.

According to the invention, this object is achieved due to the fact that said control circuit includes a generator circuit to generate said first and second clock signals, first and second delay circuits controlled by said first and second clock signals, and means generating a third reset signal which resets said generator circuit and is synchronized with said clock signals and delayed, in said first and second delay circuits to obtain said first and second reset signals with a predetermined phase relation which is such that after reset of said processing means and of said serializing and synchronizing circuit respectively, said processed digital signals are multiplexed by said multiplexing device at multiplexing instants which are located outside value transitions of said processed digital signals and which are independent from relative phase shifts between said first and second clock signals.

As a result, the processed digital signals are always synchronized with the second clock signal, even when a phase shift occurs between the first and the second clock signal. This independency of the latter possible phase shifts is obtained by the control of at least one of the delay circuits by both the first and the second clock signal.

Other characteristic features of the present invention are that said generator circuit includes a detection circuit for detecting a value transition of said third reset signal and that said detection circuit includes a first and a second flipflop connected in cascade and both controlled by said second clock signal, said third reset signal being applied to an input of said first flipflop, and a decision logic to respective inputs of which outputs of said first and second flipflops are connected respectively, a control signal being provided at an output of said decision logic to reset a counter circuit included in said generator circuit, that said counter circuit of said generator circuit is controlled by said second clock signal and has a maximum count value indicative of the frequency ratio between said first and said second clock signal, said counter circuit generating a third clock signal which is buffered by buffer means additionally included in said generator circuit and which generates said first clock signal, that said first delay circuit includes at least three cascaded flipflops, connected to said output of said second flipflop of said detection circuit and at an output of the last flipflop of which said second reset signal is generated and that said second delay circuit includes a plurality of cascaded flipflops, connected to said output of said second flipflop of said detection circuit and at an output of the last flipflop of which said first reset signal is generated, said last flipflop being controlled by said first clock signal.

In this way the predetermined phase relationship can be realized between the first and the second reset signal. At the same time a predetermined phase relationship is realized between the first and second reset signals and the first and second clock signals because the counter circuit is reset by the third reset signal. How the mentioned relationships are chosen is explained later.

Yet another characteristic feature of the present invention is that said serializing and synchronizing circuit includes a counter circuit with maximum count value equal to said plurality of digital signals and which is reset by said second reset signal delayed over a predetermined time interval, an output signal of said counter circuit controlling said multiplexing device.

In this way the serializing and synchronizing circuit is reset by the second reset signal.

The above mentioned and other objects and features of the invention will become more apparent and the invention itself will be best understood by referring to the following description of an embodiment taken in conjunction with the accompanying drawings wherein :
Fig 1 represents a processing, serializing and synchronizing device P, S, C according to the invention;
Fig. 2 shows the circuit S of Fig. 1 in more detail;
Fig. 3 represents the control circuit C of Fig. 1 in more detail;
Fig. 4 is a time diagram of signals appearing at predetermined points of the circuit C of Fig. 3;
Fig. 5 is a time diagram of signals appearing at predetermined points of circuit S of Fig. 2 when the signal CLK4BUF of Fig. 4 corresponds to the signal CLK4;
Fig. 6 shows the same signals as Fig. 5 but for CLK4BUF delayed over 2 1/2 clock periods of CLK with respect to CLK4; and
Fig. 7 represents part of the signals of Figs. 4 and 5 but where CLK4BUF is delayed over 3 1/2 period of CLK with respect to CLK4.

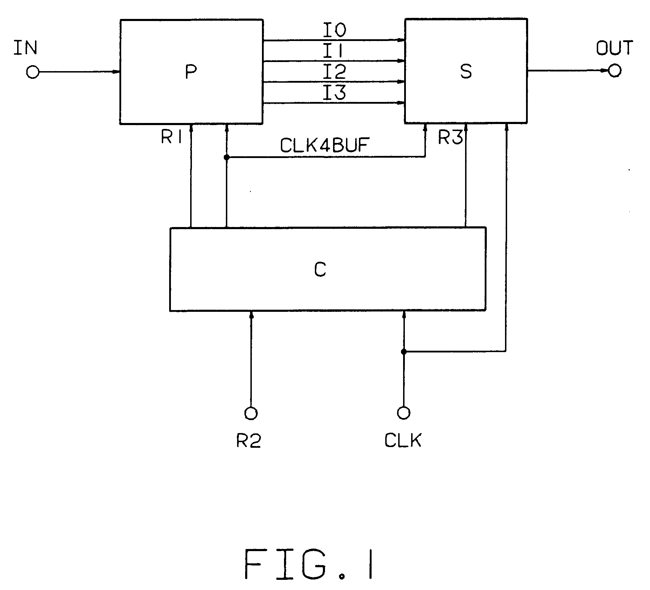

The processing, serializing and synchronizing device of Fig. 1 has 3 input terminals IN, R2 and CLK at which a digital input signal IN synchronous with a 160 MHz clock signal, a reset signal R2 for instance generated under control of an operator, and a clock signal CLK with a frequency of 160 MHz are applied respectively, and an output terminal OUT where a like named digital output signal synchronous with CLK is provided.

The device includes a processing circuit P wherein the signal IN is demultiplexed into 4 digital signals which are processed in parallel at a speed of 40 MHz. P is reset by a reset signal R1 and controlled by a clock signal CLK4BUF having a frequency of 40 MHz. It generates 4 output signals I0 to I3 which are the processed digital signals and which are applied to respective like named inputs of a serializing and synchronizing device S controlled by the clock signal CLK4BUF, by a reset signal R3 and by the clock signal CLK. S generates the output signal OUT.

The device additionally includes a control circuit C to respective inputs of which the signals R2 and CLK are applied and which generates the reset signals R1 and R3 and the clock signal CLK4BUF.

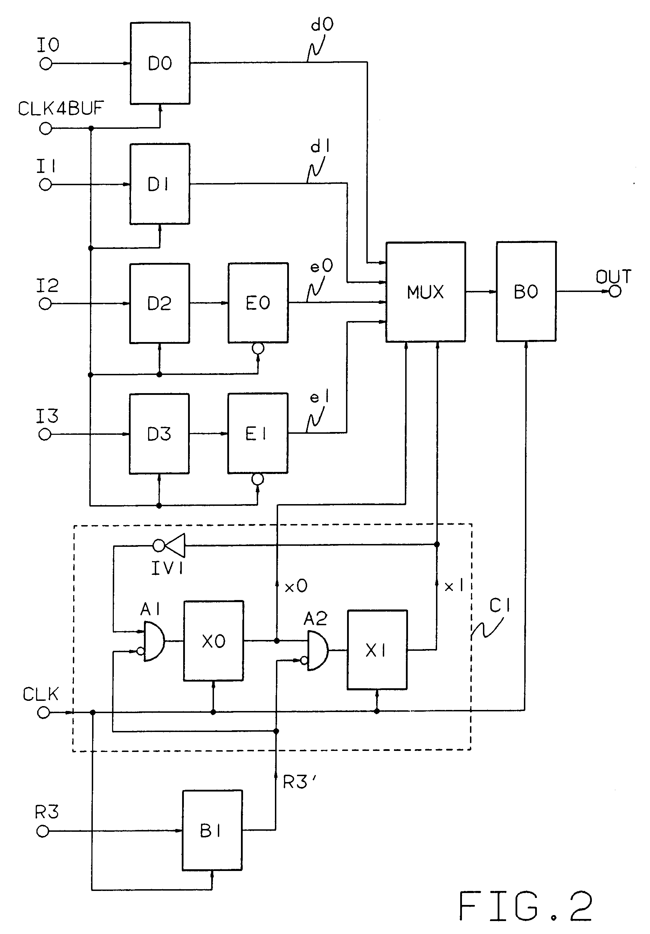

The serializing and synchronizing circuit S is shown in more detail in Fig. 2. It includes 4 D-flipflops D0 to D3 having the respective inputs I0 to I3 to which the signals I0 to I3 of P are applied. The outputs of D2 and D3 are connected to an input of D flipflops E0 and E1 respectively. D0, D1, E0 and E1 generate signals d0, d1, e0 and e1 respectively which are applied to distinct inputs of a multiplexer MUX an output of which is connected with an input of a D flipflop B0 which generates the output signal OUT.

S additionally includes a counter circuit C1 of the well known Johnson type and comprising two D flipflops X0 and X1, 2 AND gates A1 and A2, each with one inverting input, and an invertor IV1. An output of XO is via a non-inverting input of A2 coupled to an input of X1 an output of which is via IV1 and a non-inverting input of A1 in series, coupled back to an input of X0. The outputs of X0 and X1 are connected to respective control inputs of MUX where respective signals x0 and x1 are applied.

A reset signal R3' generated by a D flipflop B1 is applied to the inverting input of both A1 and A2, whilst the reset signal R3 from the control circuit C is applied to an input of B1.

The flipflops D0 to D3, E0 and E1 are controlled by the clock signal CLK4BUF, whilst the other flipflops of S are controlled by CLK.

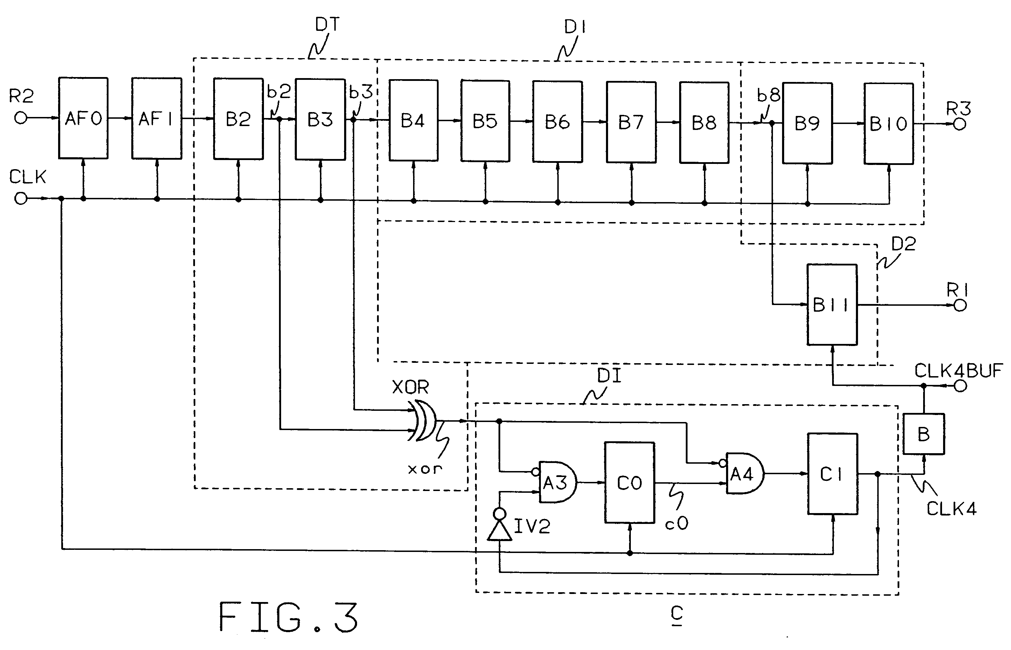

Hereafter the control circuit C of Fig. 3 is described in more detail.

C includes a cascade connection of 11 D flipflops AF0, AF1 and B2 to B10. The reset signal R2 is applied to an input of AF0 and the reset signal R3 is generated by B10. The output of the 9th flipflop B8 is not only connected to B9, but also to an input of a D flipflop B11 which is controlled by CLK4BUF and generates the reset signal R1.

The 3th and the 4th flipflops B2 and B3 generate signals b2 and b3 respectively which are applied to respective inputs of an XOR gate XOR providing a signal xor.

B2, B3 and XOR form a detection circuit DT, whilst B4 to B10, and B4 to B8 and B11 constitute 2 delay circuits D1 and D2 respectively.

C additionally includes a counter circuit DI which is a well known Johnson counter comprising 2 D flipflops C0 and C1, 2 AND gates A3 and A4, each with an inverting input and an invertor IV2. An output of C0, where a signal c0 is generated, is coupled to an input of C1 via A4, whilst an output of C1 is coupled back to an input of C0 via IV2 and A3 in series. At the outputs of C0 and C1 a signal c0 and the clock signal CLK4 are generated respectively.

The signal xor is applied to the inverting inputs of both A3 and A4 and CLK4 is applied to an input of a buffer circuit B which generates CLK4BUF. DT, DI and B form a generator circuit which generates the clock signal CLK4BUF from the clock signal CLK.

All flipflops but B11 are controlled by the clock signal CLK.

To be noted that all D flipflops of the processing, serializing and synchronizing device are positive edge triggered ones, except E0 and E1.

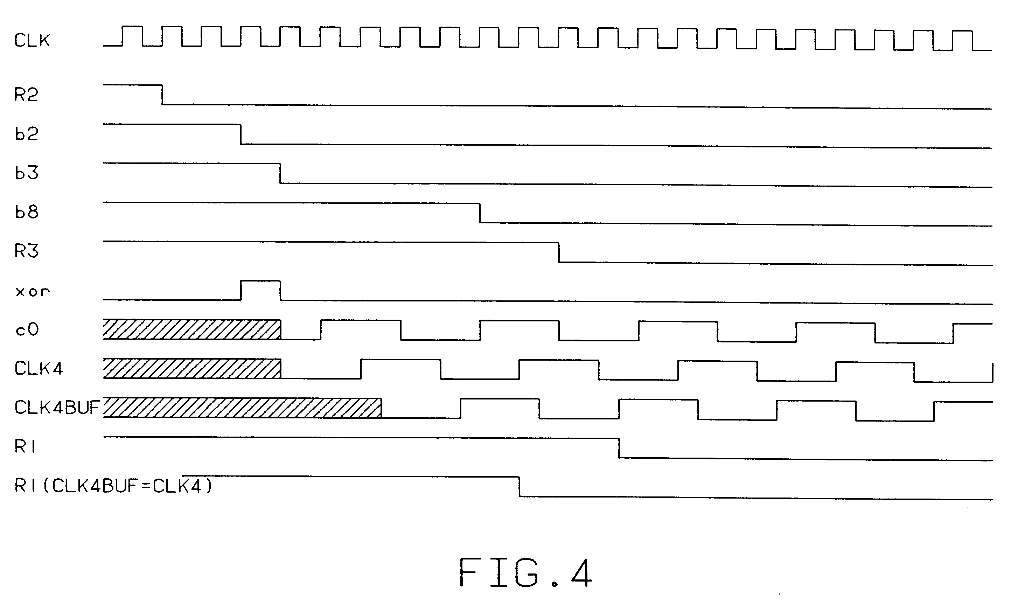

Following is now, with reference to Figs. 1 to 3 and to the time diagrams of Figs. 4 to 7, a description of the working of the device, with first a description of the generation of the signals CLK4, CLK4BUF, R1 and R3 by the control circuit C.

The signal R2, which is an asynchronous reset is first synchronized with CLK by the flipflops AF0 and AF1. The thus obtained synchronous reset is delayed in B2 and B3, the output signals b2 and b3 of which are compared by means of the XOR gate XOR. When b2 and b3 are different, i.e. when a signal transition of R2 is detected, xor becomes active as shown in Fig. 4 and resets DI. DI divides the clock signal CLK in 4 thereby generating the clock signal CLK4, which is buffered and thus delayed in B to obtain the clock signal CLK4BUF.

The signal b3 is by means of B4 to B10, and of B4 to B8, which generates a signal b8, and B11 delayed over 7 clock periods of CLK and over 5 clock periods of CLK plus maximum 1 clock period of CLK4BUF to obtain the reset signals R3 and R1 respectively. The latter reset signals are thus delayed over a predetermined time interval with respect to R2 which is such that they do not become active before the clock signal CLK4BUF is stable, whilst the delay of R3 with respect to R1 is such that, after the reset of the processing means P, stable and defined data is present at the input of the multiplexer MUX at the moment the counter circuit C1 is reset by R3.

This can be seen in Fig. 4 which shows the thus obtained phase relations between the signals CLK, CLK4, CLK4BUF, R1, R2 and R3 and where R1 is shown once for CLK4BUF equal to CLK4 (R1(CLK4BUF = CLK4)) and once for CLK4BUF having a delay of 2 1/2 clock periods of CLK with respect to CLK4 (R1). These two delays are considered in order to determine , as will be explained later, the boundaries of the phase shift of CLK4BUF with respect to CLK4 within which the processing, serializing and synchronizing circuit can work correctly.

It has to be noted that the flipflop B1 is implemented in the serializing and synchronizing circuit S instead of in C as part of D1, in order to keep the delay of R'3 between the output of B1 and A2 as small as possible.

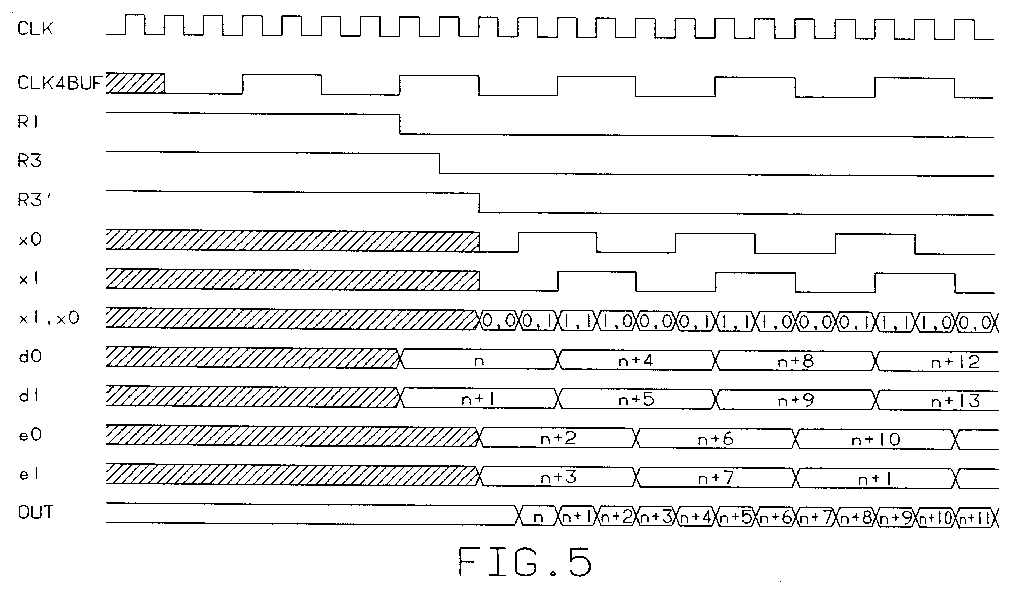

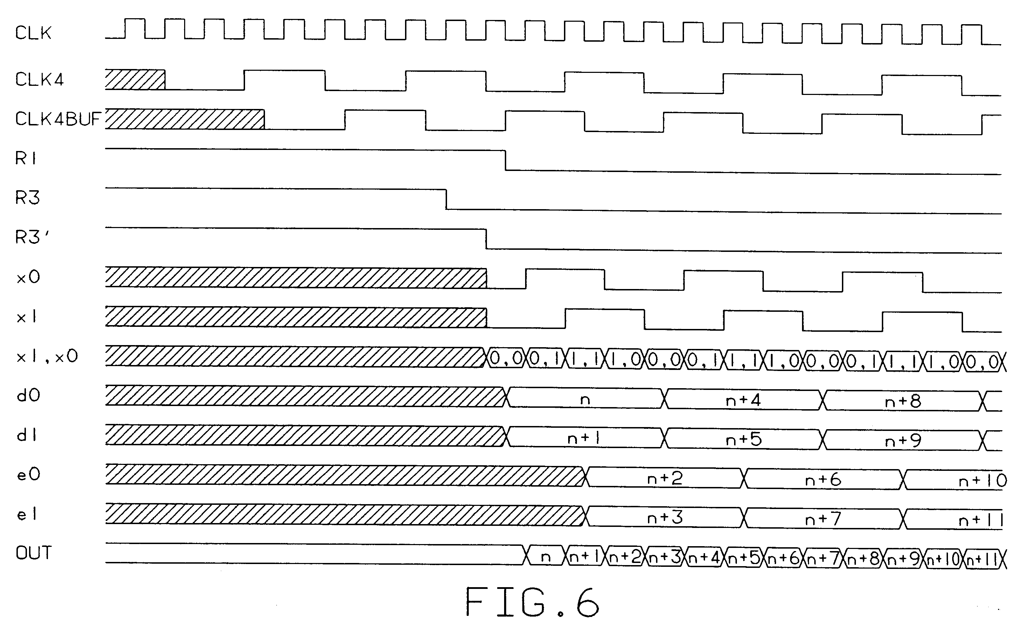

Figs. 5 and 6 show how the signals I0 to I3 are sampled by MUX and B0 after having been delayed over 1 clock period of CLK4BUF, for I0 and I1, and 1 1/2 clock periods of CLK4BUF for I2 and I3, by D0, D1 and D2,E0; D3, E1 respectively and this again when CLK4BUF equals CLK (Fig. 5) and when CLK4BUF is delayed over 2 1/2 clock period of CLK (Fig. 6).

First the case of CLK4BUF = CLK4 is considered. As can be seen on Fig. 5, the counter circuit C1 of Fig. 2, is reset by R3' which is obtained by delaying R3 over 1 clock period of CLK by means of B1. This reset thus occurs 2 clock periods of CLK after the processing circuit P is reset by R1. As a consequence, the multiplexer MUX starts mutiplexing d0, d1, e0 and e1 2 clock periods of CLK after the appearance of meaningful data at its inputs and the multiplexed data appears at the output of B0, as the output data OUT, 1 clock period of CLK later.

It has to be noted that the above mentioned meaningful data is not necessarily input data of P, since IN can be delayed by P. By meaningful data is meant data which is not undefined. The meaningful sequenced data bits are indicated on Fig. 5 by n, n+1, n+2, etc. where n is part of d0, n+1 is part of d1, n+2 is part of d3, etc. in a cyclic way.

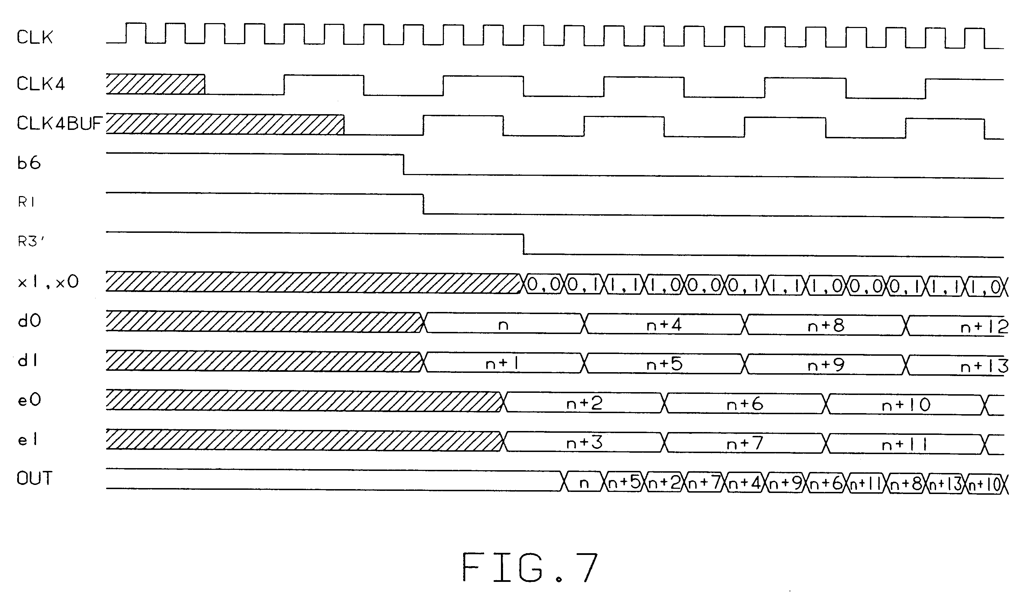

It can be seen on Fig. 5 that the multiplexing or sampling of d0 and e0 by MUX and B0 occurs at a stable instant of these signals, whilst the sampling of d1 and e1 occurs at the transitions thereof. This extreme situation is considered to show that the phase shift between CLK4BUF and CLK4 has to be greater than 0 which is obviously the case since CLK4BUF is deduced from CLK4. When this delay remains below a maximum value, which will be determined later, d0, d1, e0 and e1 are stable when being sampled by MUX and B0 and the sampling instant and thus the output signal OUT remain the same irrespective of the phase delay between CLK4BUF and CLK4. This can be seen on Fig. 6 where the same signals are shown as on Fig. 5 but with CLK4BUF delayed over 2 1/2 clock period of CLK with respect to CLK4. It can also be seen on this figure that in case of a further delay of 1/2 clock period of CLK for CLK4BUF with respect to CLK4, d0 and e0 will be sampled at their transitions. For even further delays the sequence of the arriving bits can be mixed up, since the positive edge of CLK4BUF which on Fig. 4 occurs before the negative edge of b8, will then occur after the latter edge and consequently meaningful data will appear at MUX well before C1 is reset and the sampling is started. For instance for a delay of 3 1/2 period of CLK for CLK4BUF with respect to CLK4, as shown on Fig. 7, the transition of R1 occurs 3 clock periods of CLK earlier than on Fig. 6. As a consequence bits n+1, n+3, ... are already overwritten by n+5, n+7, ... at the moment they are sampled and the sequence of the bits is mixed up as can be seen on Fig. 7.

From the above description thus follows that the phase relations between R1, R3, CLK4 and CLK4BUF realized by C are such that when the relative delay of CLK4BUF with respect to CLK4 remains larger than 0 but smaller than 3 clock periods of CLK, d0, d1, e0 and e1 are stable when being sampled by MUX and B0 and that they are then sampled at a constant absolute instant in time and in the correct sequence, independently of the value of that delay. This independency is realized by using R2 to control the generation of CLK4, and CLK4 and CLK4BUF to control the generation of R1.

It has to be noted that the above phase interval is a theoretical one. Indeed in the above description and in the time diagrams of Figs. 4 to 7 implementation specific time delays such as setup delays, hold delays, etc... have not been taken into account. As a result of these delays, the mentioned interval can in practice be subject to small variations which can be determined experimentally.

It has also to be noted that the number of flipflops in D1 and D2 could be reduced whilst still sampling the digital signals at stable instants. The reason for having the shown amount of flipflops is that the sampling should occur as close as possible to the trailing edge of a data bit in order to allow a relatively long set up delay of the digital signals.

While the principles of the invention have been described above in connection with specific apparatus, it is to be clearly understood that this description is made only by way of example and not as a limitation on the scope of the invention.

## Claims

1. Processing, serializing and synchronizing device including a processing means (P) able to process a plurality of digital signals under control of a first clock signal (CLK4BUF) and to be reset by a first reset signal (R1), a serializing and synchronizing circuit (S) able to be reset by a second reset signal (R3) and including a multiplexing device (MUX, B0) to convert the thus processed plurality of digital signals to a serialized output signal (OUT) synchronous with a second clock signal (CLK), and a control circuit (C) generating said first (CLK4BUF) and second (CLK) clock signals, characterized in that said control circuit (C) includes a generator circuit (DT, DI, B) to generate said first (CLK4BUF) and second (CLK) clock signals, first (D1) and second (D2) delay circuits controlled by said first (CLK4BUF) and second (CLK) clock signals, and means generating a third reset signal (R2) which resets said generator circuit and is synchronized with said clock signals and delayed, in said first and second delay circuits to obtain said first (R1) and second (R3) reset signals with a predetermined phase relation which is such that after reset of said processing means (P) and of said serializing and synchronizing circuit (S) respectively, said processed digital signals are multiplexed by said multiplexing device (MUX, B0) at multiplexing instants which are located outside value transitions of said processed digital signals and which are independent from relative phase shifts between said first and second clock signals.

2. Processing, serializing and synchronizing device according to claim 1, characterized in that said generator circuit (DT, DI, B) includes a detection circuit for detecting a value transition of said third reset signal (R2) and that said detection circuit (DT) includes a first (B2) and a second (B3) flipflop connected in cascade and both controlled by said second clock signal (CLK), said third reset signal (R2) being applied to an input of said first flipflop, and a decision logic (XOR) to respective inputs of which outputs (b2, b3) of said first and second flipflops are connected respectively, a control signal (xor) being provided at an output of said decision logic to reset a counter circuit (DI) included in said generator circuit.

3. Processing, serializing and synchronizing device according to claim 2, characterized in that said first delay circuit (D1) includes at least three cascaded flipflops (B4, ..., B10), connected to said output (b3) of said second flipflop (B3) of said detection circuit (DT) and at an output of the last flipflop (B10) of which said second reset signal (R3) is generated.

4. Processing, serializing and synchronizing circuit according to claim 2, characterized in that said second delay circuit (D2) includes a plurality of cascaded flipflops (B4, ..., B8, B11), connected to said output (b3) of said second flipflop (B3) of said detection circuit (DT) and at an output of the last flipflop (B11) of which said first reset signal (R1) is generated, said last flipflop being controlled by said first clock signal (CLK4BUF).

5. Processing, serializing and synchronizing circuit according to claim 3, characterized in that the frequency of said first clock signal (CLK4BUF) is a fourth of the frequency of said second clock signal (CLK) and that said first delay circuit (D1) includes 7 flipflops (B4, ..., B10) controlled by said second clock signal (CLK).

6. Processing, serializing and synchronizing circuit according to claims 4 and 5, characterized in that said second delay circuit (D2) includes the first 5 flipflops (B4, ..., B8) of said first delay circuit (D1) the last flipflop of which (B8) is connected to a flipflop (B11) controlled by said first clock signal (CLK4BUF).

7. Processing, serializing and synchronizing device according to claim 2, characterized in that said counter circuit (DI) of said generator circuit (DT, DI, B) is controlled by said second clock signal (CLK) and has a maximum count value indicative of the frequency ratio between said first (CLK4BUF) and said second (CLK) clock signal, said counter circuit generating a third clock signal (CLK4) which is buffered by buffer means (B) additionally included in said generator circuit and which generates said first clock signal (CLK4BUF).

8. Processing, serializing and synchronizing device according to claim 7, characterized in that said frequency ratio is 1:4 and that said counter circuit (DI) includes two flipflops (C0, C1) an output of a first one (C0) of which is connected to an input of the second one (C1) via a first input of a first decision logic (A4), whilst an output of said second one (C1) is connected to an input of said first one (C0) via a first input of a second logic (A3), said control signal (xor) being applied to a second input of said first (C1) and said second (C0) logic.

9. Processing, serializing and synchronizing device according to claim 1, characterized in that said serializing and synchronizing circuit (S) includes a counter circuit (C1) with maximum count value equal to said plurality of digital signals and which is reset by said second reset signal (R3) delayed over a predetermined time interval, an output signal of said counter circuit controlling said multiplexing device (MUX, B0).

10. Processing, serializing and synchronizing device according to claim 1, characterized in that said serializing and synchronizing circuit (S) additionally includes a first plurality of flipflops (D0, ..., D3, E0, E1) controlled by said first clock signal (CLK4BUF) and subdivided in second pluralities of flipflop sets, said second plurality being equal to the plurality of digital signals, each one of said processed digital signals being applied to a respective one of said sets, the flipflops of each of said sets being connected in cascade and an output of the last flipflop of said cascade being aplied to a respective input of said multiplexing device (MUX, B0).

11. Processing, serializing and synchronizing device according to claim 10, characterized in that the frequency of said first clock signal (CLK4BUF) is a fourth of the frequency of said second clock signal (CLK) whilst said plurality of digital signals equals 4, 2 of said flipflop sets comprising one flipflop (D0;D1) each, whilst the other two sets include 2 flipflops (D2, E0; D3, E1) each.
